# EUROPEAN PATENT APPLICATION

(11) **EP 2 835 444 A1**
(43) Date of publication of application: **11.02.2015**
(21) Application number: 13769688.6
(22) Date of filing: 08.03.2013
(51) Int. Cl.: C23C 14/00

(54) **VACUUM FILM DEPOSITION DEVICE AND VACUUM FILM DEPOSITION METHOD**

(30) Priority: 29.03.2012 JP 2012076494
(71) Applicant: Toray Industries, Inc., Tokyo 103-8666 (JP)
(72) Inventor: KAWASHITA, Mamoru, Otsu-shi Shiga 520-8558 (JP); NOMURA, Fumiyasu, Otsu-shi Shiga 520-8558 (JP)
(74) Representative: Hoefer & Partner
(86) International application number: PCT/JP2013/056436
(87) International publication number: WO 2013/146182

(57) **Abstract**

In order to provide an adhesion preventing plate for a vacuum film formation apparatus, the adhesion preventing plate being capable of suppressing the peel-off of an adhered film to an extremely low level regardless of a protection target member, the adhesion preventing plate is arranged so that the area of contact with the protection target member is reduced and a part other than the contact surface is thermally insulated.

## Description

### TECHNICAL FIELD

The present invention relates to a vacuum film formation apparatus and a vacuum film formation method.

### BACKGROUND ART

There are various methods having different characteristics as means for applying a functional film onto a substrate, and an appropriate method is selected and used depending on characteristics required for a functional film and the productivity. A vacuum film formation method such as a deposition method, a sputtering method, and a CVD method is a technique for forming a thin film on a substrate by allowing particles of a film formation substance to be adhered and deposited on the substrate inside a vacuum chamber. However, particles of the film formation substance adhere to a place other than the substrate, for example, to an inner wall of the vacuum chamber or a conveyance device for the substrate and a film adhered to the place other than the substrate peels off and affects the substrate, which disadvantageously causes product defects or leads to equipment troubles. In order to avoid such problems, an adhesion preventing plate is generally provided in a place to which particles of a film formation substance desirably do not adhere other than the substrate.

A method in which a target portion is covered by aluminum foil or copper foil and the entire foil is discarded after every single batch of film formation is used as a method capable of simply obtaining an adhesion preventing effect. However, in this method, the amount of waste increases and a large load is also generated in a running cost.

Therefore, there is also used a method in which a metal plate is used as an adhesion preventing plate instead of foil, and a film of a film formation substance adhered to the adhesion preventing plate is peeled off to reuse the adhesion preventing plate, thereby reducing the amount of waste. However, in this method, a film adhered to the adhesion preventing plate peels and falls off and thereby generates dust during film formation, and the generated dust adheres to the substrate and gives an adverse effect on the film formation, which induces product defects.

In Patent Document 1, there is described a form of an adhesion preventing plate used in an ITO sputtering apparatus. Described is a technique for roughening the surface of the adhesion preventing plate to expand the contact area in order to improve the adhesion between the adhesion preventing plate and an ITO film. The adhesion preventing plate can be reused by removing the ITO film adhered thereto by etching or blast.

Further, in Patent Document 2, there is described a form of an adhesion preventing plate used in a thin film producing apparatus. Described is a technique for ensuring the adhesion by forming a groove on the surface of the adhesion preventing plate and applying a thermal spraying film onto a surface layer. It is possible to reuse the adhesion preventing plate by peeling off the entire thermal spraying film adhered to the adhesion preventing plate and again applying a thermal spraying film thereto.

Further, in Patent Document 3, there is described a form of a metal film peel-off preventing structure in a metal film forming apparatus. This structure is characterized in that, in order to prevent a metal film adhered and deposited on a specified member from peeling and falling off from the member, a thermal spay film made of aluminum or an aluminum alloy is formed on the surface of the member and the surface is moderately roughened. Described is a technique for giving an adhered film stress relaxation effect to the thermal spraying film while improving the adhesion by increasing the surface area by the roughening to thereby prevent the peel-off.

All of the above methods have a certain degree of effect on peel-off prevention. However, according to the knowledge of the inventors of the present application, in a step of continuously forming a film for a long period of time or a process in which the film formation speed is extremely high, the film stress increases as the thickness of a film deposited on an adhesion preventing plate increases, and the adhered film often peels off when the film stress overcomes the adhesion. Further, in an adhesion preventing plate for protecting a cooling member, the adhesion preventing plate itself is affected by cooling due to heat transfer, and particles of a film formation substance flying to the adhesion preventing plate form a film while being rapidly cooled. Therefore, the film stress becomes extremely large, and the formed film quickly peels off from the adhesion preventing plate. In the use in such a process in which the film stress increases, the effect is not sufficient.

In Patent Document 4, there is described a form of an adhesion preventing plate used for the purpose of solving the above problems. Described is a technique for directly adjusting the temperature of the adhesion preventing plate itself. With this technique, a difference in temperature between film formation particles and the adhesion preventing plate is optimized and film formation is performed with the smallest possible film stress, thereby preventing the peel-off caused by the film stress. According to the knowledge of the present inventors, this method can extremely effectively prevent the peel-off of an adhered film, but has problems as described below.

First, it is necessary to place a heater or a cooler for temperature adjustment, or both the heater and the cooler on the adhesion preventing plate. Therefore, the size of the adhesion preventing plate itself increases. As a result, an area which blocks film formation particles is made larger, which causes an extremely significant adverse effect for the film formation apparatus such as a decrease in the film formation rate.

Further, it is basically preferred that a smaller number of structures be provided inside the vacuum film formation apparatus because of the influence of outgas received from the members. However, it is necessary to attach the heater or the cooler to the adhesion preventing plate in order to adjust the temperature of the adhesion preventing plate itself, and it is therefore necessary to provide an extra heater or cooler inside the vacuum chamber. An extra discharge time may be required or the degree of vacuum may vary during the temperature adjustment due to the influence of outgas depending on the material or the structure of the heater or the cooler. Further, it is necessary to introduce a heat medium, a power source and the like of the heater or the cooler into the vacuum chamber from the atmosphere side. Therefore, an undesirable risk for the vacuum apparatus such as vacuum leakage which may occur in the introduction part is caused.

### PRIOR ART DOCUMENTS

### PATENT DOCUMENTS

Patent Document 1: Japanese Patent Laid-open Publication No. 8(1996)-333678
Patent Document 2: Japanese Patent Laid-open Publication No. 2006-57172
Patent Document 3: Japanese Patent Laid-open Publication No. 2008-291299
Patent Document 4: Japanese Patent Laid-open Publication No. 6(1994)-322528

### SUMMARY OF THE INVENTION

### PROBLEMS TO BE SOLVED BY THE INVENTION

An object of the present invention is to solve the above problems and provide a vacuum film formation apparatus having high quality and high stability and a vacuum film formation method by providing an adhesion preventing plate that can be reused and exhibit both a function of preventing film formation on a protection target member and a function of preventing the peel-off of a film adhered to the adhesion preventing plate.

### SOLUTIONS TO THE PROBLEMS

In order to achieve the above object, one aspect of the present invention provides a vacuum film formation apparatus which forms a film of a film formation substance on a substrate and includes an adhesion preventing plate which is arranged to cover at least a part of a protection target member and prevents adhesion of particles of the film formation substance to the protection target member, wherein the adhesion preventing plate is arranged in such a manner that the area of a contact surface between other structure including the protection target member and the adhesion preventing plate is made smaller than the area of a film adhesion surface of the adhesion preventing plate to which particles of the film formation substance are adhered, and a first heat insulation member is provided between a surface other than the contact surface of the adhesion preventing plate and other structure including the protection target member.

Further, according to a preferred aspect of the present invention, the vacuum film formation apparatus in which the protection target member is cooled by cooling means is provided.

Further, according to another preferred aspect of the present invention, the vacuum film formation apparatus in which the contact surface between other structure including the protection target member and the adhesion preventing plate is provided only on a far side from a film formation source of the film formation substance is provided.

Further, according to yet another preferred aspect of the present invention, the vacuum film formation apparatus in which contact between other structure including the protection target member and the adhesion preventing plate is performed in an end part of the adhesion preventing plate is provided.

Further, according to yet another preferred aspect of the present invention, the vacuum film formation apparatus in which a thermal spraying film is formed on the film adhesion surface of the adhesion preventing plate by a thermal spraying method is provided.

Further, according to yet another preferred aspect of the present invention, the vacuum film formation apparatus in which a second heat insulation member is attached to a contact surface on which a member to which the adhesion preventing plate is attached and the adhesion preventing plate make contact with each other so as to be interposed between the member and the adhesion preventing plate is provided.

Further, according to yet another preferred aspect of the present invention, a vacuum film formation method using the vacuum film formation apparatus according to any one of the above aspects is provided.

In the prevent invention, "protection target member" indicates a member that is located at a position directly exposed from a film formation source and required to be protected from adhesion of particles of a film formation substance. For example, the protection target member includes a component of the film formation source, a vacuum chamber inner wall, and a partition wall.

In the present invention, "heat insulation member" indicates an object having a structure in which heat is less likely to be transferred or a substance having low thermal conductivity. For example, glass wool and foamed polyurethane fall within the former, and silicone rubber and air fall within the latter. Further, vacuum is also regarded as the heat insulation member in the present invention.

### EFFECTS OF THE INVENTION

According to the present invention, as described below, it is possible to obtain a vacuum film formation apparatus that is provided with an adhesion preventing plate having a simple structure in which the peel-off/fall-off of the adhered film is extremely less likely to occur. Therefore, film formation using the vacuum film formation apparatus according to the present invention makes it possible to form a high-quality film without being affected by the occurrence of defects caused by caught dust and deterioration of the film quality due to abnormal discharge caused by dust.

### BRIEF DESCRIPTION OF THE DRAWINGS

Fig. 1 is a schematic cross-sectional view of an example of a vacuum film formation apparatus according to the present invention when being configured with a target holding member for a magnetron sputtering electrode defined as a protection target member.
Fig. 2 is a schematic cross-sectional view of an example of the vacuum film formation apparatus according to the present invention in which an adhesion preventing plate is arranged on a vacuum chamber wall surface.

### EMBODIMENT OF THE INVENTION

Hereinbelow, an example of the best mode of the present invention will be described with reference to the drawings taking a case where a roll to roll type vacuum film formation apparatus according to the present invention is configured with a target holding member for a magnetron sputtering electrode defined as a protection target member as an example. The present invention relates to the configuration of an adhesion preventing plate of the vacuum film formation apparatus. Therefore, the structure of the magnetron sputtering electrode and the configuration of the protection target member which both dot not directly relate to the configuration of the adhesion preventing plate and film formation means are not limited to the contents described below. In the following description, a peripheral structure of the adhesion preventing plate according to the present invention, for example, the structure of the sputtering electrode is merely specifically described for the purpose of explaining the configuration of the adhesion preventing plate according to the present invention in an easily understandable manner.

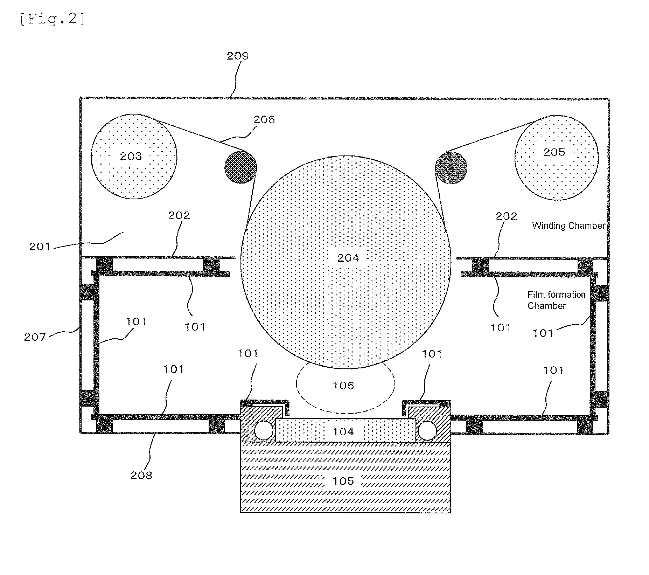

Fig. 2 is a schematic cross-sectional view of the vacuum film formation apparatus. In the apparatus, a substrate conveyance system which includes an unwinder 203, a main roller 204, a winder 205, and various guide rollers (not numbered), and a film formation source (a spattering electrode is used as an example in this drawing) are housed inside a vacuum chamber 201, and a film is formed on a substrate 206 by a sputtering method while conveying the substrate 206 by the substrate conveyance system after the vacuum chamber 201 is evacuated. It is general that the inside of the vacuum chamber 201 is divided into a film formation chamber in which film formation is performed and a winding chamber in which the substrate conveyance system is housed, and a partition wall 202 is provided in order to separately perform pressure control in different points of view. As the substrate 206, various webs including a plastic film are used. In a vacuum film formation apparatus that is not a roll to roll type, for example, a single wafer processing type vacuum film formation apparatus, a silicon wafer, a glass plate or the like may be used as the substrate.

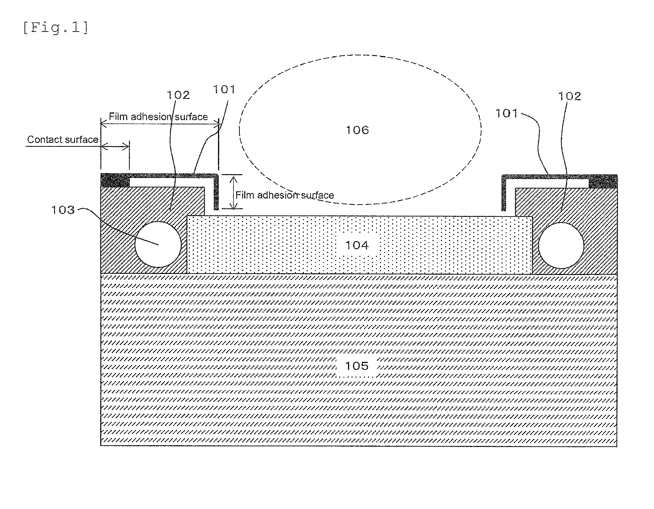

Fig. 1 is a schematic cross-sectional view of the vacuum film formation apparatus according to the present invention when being configured with a target holding member for a magnetron sputtering electrode generally used as a film formation source for a vacuum film formation apparatus defined as the protection target member. A sputtering target 104 is mounted on a sputtering electrode 105, and fixed by a target holder which is a protection target member 102. A magnet for forming a magnetic field is provided near the protection target member 102. A coolant path 103 is provided inside the protection target member 102 so as to prevent demagnetization caused by heat transfer from the heated protection target member 102, and cooling is performed using any cooling means such as allowing water or oil as coolant to pass through the coolant path 103.

The electrode is placed inside the vacuum chamber and voltage is applied between the sputtering electrode 105 and an anode which is electrically insulated from the sputtering electrode 105 to generate plasma discharge in a discharge space 106, and the sputtering target 104 is thereby sputtered to release a target material as particles of a film formation substance so as to be adhered and deposited on the substrate to form a film. Any anode can be used as long as it is electrically insulated from the sputtering electrode 105 and functions as an electrical counter electrode of the sputtering electrode 105 (cathode). For example, the main roller 204, a vacuum chamber wall surface 207, a vacuum chamber bottom surface 208, and a vacuum chamber top surface 209 can serve as the anode as long as they are insulated from the sputtering electrode 105. Further, the film formation substance indicates a substance for exhibiting a desired function by being deposited on the substrate as a thin film, and is appropriately selected totally taking into consideration the function, cost, and the like. For example, copper is used as the film formation substance in a product for a circuit board, or aluminum is used as the film formation substance in a product for a package material.

The sputtering target 104 is a film formation source, and particles of the film formation substance released from the film formation source scatter in all directions. Therefore, some components may be adhered to the protection target member 102 . When particles of the film formation substance are adhered and deposited on the protection target member 102 and thereby form a film, the electrical, thermal, magnetic, and physical characteristics of the protection target member 102 may be changed depending on the physical property thereof, which may cause an unstable discharge condition. Further, when the adhered film peels off, the peeled-off film itself becomes dust, or induces arc discharge and thereby generates dust. As a result, a risk of giving an adverse effect on the quality of the film formed on the substrate increases.

Therefore, an adhesion preventing plate 101 is provided so as to cover a surface of the protection target member 102 to which particles of the film formation substance are adhered. The adhesion preventing plate 101 is arranged in such a manner that the adhesion preventing plate 101 and the protection target member 102 are allowed to make contact with each other only on a contact surface and a first heat insulation member is provided between the adhesion preventing plate 101 and the protection target member 102 in a part other than the contact surface. Such a configuration makes it possible to suppress a decrease in the temperature of the adhesion preventing plate 101 and prevent heat release from the part other than the contact surface in which transmission/reception of heat is performed.

The mechanism will be more specifically described. The adhesion preventing plate 101 is heated by collision energy of ions or atoms during film formation. By limiting the contact surface to a small area in accordance with the technical idea of the present invention and providing a heat insulation structure to the part other than the contact surface, it is possible to increase the temperature of the adhesion preventing plate 101 itself up to a temperature at which the amount of heat released from the contact surface and the amount of heat received by the adhesion preventing plate 101 are in balance with each other without performing temperature adjustment from the outside. Further, a heat source which heats the adhesion preventing plate 101 is derived from film formation energy. Therefore, the temperature of the adhesion preventing plate 101 is adjusted in the course of nature without performing any special adjustment in such a manner that the temperature is made high at a high film formation rate and low at a low film formation rate so that the temperature of the adhesion preventing plate 101 gets close to a temperature suitable for forming a film with a film formation component maintaining the film stress at a low level. This tendency is likely to remarkably appear in a place located closer to the film formation source. Therefore, the present invention is particularly preferably used as an adhesion preventing plate for covering the protection target member 102 which is adjacent to the film formation source. On the other hand, when not in accordance with the technical idea of the present invention, the amount of heat received in the adhesion preventing plate 101 is immediately released from a wide contact surface, and the temperature of the adhesion preventing plate 101 therefore does not increase. As a result, the object of the present invention cannot be achieved. Further, when a large structure is placed at a position adjacent to the film formation source, film formation particles are obstructed from flying toward the substrate from the film formation source in many cases, which directly results in a decrease in the film formation rate and is therefore not preferred. However, the adhesion preventing plate of the present invention has a simple structure and can be downsized. Therefore, it is possible to minimize a decrease in the film formation rate, or prevent the occurrence of a decrease in the film formation rate. In Fig. 1, the protection target member 102 is arranged exactly adjacent to the sputtering target 104 as the film formation source. However, even when any object is interposed between the film formation source and the protection target member, the protection target member can be regarded as being adjacent to the film formation source as long as it is arranged close to the film formation source and in a state exposed to the flying film formation particles, and can be regarded as being substantially adjacent thereto. The shape of the protection target member 102 is not limited to one illustrated in Fig. 1, and the protection target member 102 may be a structure mounted on the upper surface of the sputtering target 104 or a structure that is arranged next to the sputtering target 104 so as to form the same plane as the upper surface of the sputtering target 104.

The adhesion preventing plate 101 is preferably formed from a plate-like material. A material having low thermal conductivity such as zirconia-based ceramic is preferably used as the first insulation member. Further, a vacuum insulation state is achieved by merely leaving a gap due to the vacuum environment during film formation. Therefore, leaving a gap is also preferred. The pressure of vacuum in this case may be any pressure as long as it is used in a normal vacuum film formation process, and a pressure of approximately 10³ Pa or less is sufficient. Further, there is also preferably used a structure in which a contact surface is provided in the adhesion preventing plate 101 on the far side from the sputtering target 104, a material having low thermal conductivity such as zirconia-based ceramic is provided as a first insulation member on an end on the near side, and vacuum is used as a first insulation member in the other part. In this regard, "far side" indicates a place where the distance from a center point of the sputtering target 104 is longer than the distance from a center point of the adhesion preventing plate 101, and "near side" indicates a place where the distance from the center point of the sputtering target 104 is shorter than the distance from the center point of the adhesion preventing plate 101.

A range of the distance between the adhesion preventing plate 101 and the protection target member 102, or the thickness of the first insulation member is appropriately determined in terms of the processing accuracy of the adhesion preventing plate and optimizing the ratio of reducing the sputter efficiency by a clearance with another member and the adhesion preventing plate, and preferably in the range of approximately 0.3 mm to 10 mm. When vacuum is used as the first insulation member, the thickness thereof is preferably approximately 0.3 mm to 5 mm, and when the fist insulation member is a solid insulation member, the thickness thereof is preferably approximately 1 mm to 10 mm. When particles of the film formation substance are adhered and deposited on the adhesion preventing plate 101 in a low temperature state, a film grows with a large film stress remaining therein by being rapidly cooled. As a result, the adhered film is highly likely to peel off, which is not desirable. Because the adhesion preventing plate 101 receives sputter heat or plasma heat, the adhesion preventing plate 101 is maintained at a high temperature by preventing release of the heat as far as possible to thereby suppress the film stress of the adhered film to a low level. In order to achieve this, it is effective to reduce the contact area between the adhesion preventing plate 101 and other structure including the protection target member 102, and it is preferred to place the adhesion preventing plate 101 so as to make contact with other structure member including the protection target member and the adhesion preventing plate at the end of adhesion preventing plate. The area of the contact surface between the adhesion preventing plate 101 and other structure including the protection target member 102 is preferably smaller than the area of a film adhesion surface of the adhesion preventing plate 101 to which particles of the film formation substance are adhered, and more preferably 1/2 or less of the area of the film adhesion surface. The lower limit of the contact area never physically becomes zero in view of the structure. However, the contact area is preferably as small as possible because the heat retention effect of the adhesion preventing plate itself is improved.

Further, it is more preferred to attach a second heat insulation member to the contact surface so as to be interposed between the adhesion preventing plate 101 and the protection target member 102 because the heat insulation effect is further improved. For example, there is preferably used a method in which a heat insulation member such as zirconia-based ceramic is interposed between the contact surface of the adhesion preventing plate 101 and the protection target member 102 and fastened with a bolt. In this case, a main heat transfer path passes through the bolt, and it is therefore possible to largely reduce the heat transfer efficiency.

Further, providing the contact surface of the adhesion preventing plate 101 only on the far side from the film formation source 104 is also effective in suppressing a decrease in the temperature of the adhesion preventing plate 101 in terms of making heat less likely to move. The thickness of the adhesion preventing plate is appropriately determined taking into consideration parameters such as the processing accuracy, the heat warpage resistant property, the mechanical strength, and the estimated film adhesion amount of the adhesion preventing plate, and preferably within the range of 1 mm to 3 mm due to economic reasons. Further, the above range is preferred also because an area which blocks the film formation particles is not increased by the adhesion preventing plate itself and the film formation rate is not affected.

As the material of the adhesion preventing plate, the same material as the film formation material is preferably used in view of peel-off prevention. However, the material of the adhesion preventing plate may be appropriately selected depending on the cleaning characteristics at the time of reuse, the heat characteristics, the mechanical characteristics and the like. For example, when the adhered film is removed by chemical cleaning to reuse the adhesion preventing plate, a stainless-based material having high corrosion resistance is preferably used.

Further, by roughening the surface of the adhesion preventing plate 101 with a center line average roughness of 12.5 µm or more, the contact area is increased to improve the adhesion of the adhered film. This is more preferred because a peel-off preventing function is further enhanced due to a synergistic effect with the film stress suppressing effect described above.

Further, it is more preferred to form a thermal spraying film on the surface of the adhesion preventing plate 101 by a thermal spraying method because the thermal spraying film functions as a buffer film and the peel-off preventing effect is thereby further improved. In this case, a thermal spraying material may be a metal material such as tungsten or may also be a nonmetal material such as ceramic.

Fig. 2 shows a schematic cross-sectional view of the vacuum film formation apparatus according to the present invention in which the adhesion preventing plate is arranged on the vacuum chamber wall surface. In the apparatus, the substrate conveyance system which includes the unwinder 203, the main roller 204, the winder 205, and the various guide rollers (not numbered), and the magnetron spattering electrode described above with reference to Fig. 1 are housed inside the vacuum chamber 201, and a film is formed on the substrate 206 by a sputtering method with the magnetron spattering electrode while conveying the substrate 206 by the substrate conveyance system after the vacuum chamber 201 is evacuated. It is general that the inside of the vacuum chamber 201 is divided into the film formation chamber in which film formation is performed and the winding chamber in which the substrate conveyance system is housed, and the partition wall 202 is provided in order to separately perform pressure control in different points of view.

In this system, particles of the film formation substance from the film formation source may adhere directly to a part of the vacuum chamber wall surface 207 and the partition wall 202 and indirectly to the vacuum chamber bottom surface 208 and the vacuum chamber top surface 209. Therefore, there may be a request to protect these wall surfaces as a protection target member. Also in such a case, the adhesion preventing plate 101 can be preferably used. The adhesion preventing plate 101 is particularly preferably used when it is necessary to cool a part of the vacuum chamber wall surface 207 and the partition wall 202, the part being directly exposed from the film formation source.

### EXAMPLE

### [Example 1]

The result of a film formation experiment performed using the above-described adhesion preventing plate in the target holding member for the sputtering electrode will be described.

The sputtering electrode itself has the structure shown in Fig. 1, and the protection target member 102 is a member for holding the sputtering target 104 onto the sputtering electrode 105. The temperature of the protection target member 102 tends to increase by plasma or ion attack, and the temperature increase causes various harmful effects such as thermal elongation. Therefore, the cooling water path 103 is provided inside the member and cooling water is allowed to pass through the cooling water path 103 to perform cooling. In this case, the protection target member 102 is located immediately near the sputtering target, and abnormal discharge occurs when sputtered foreign matters deposited on the protection target member 102 peel off and thereby form dust. Therefore, the adhesion preventing plate 101 is provided. The width of the film adhesion surface of the adhesion preventing plate 101 is 36 mm in total including 20 mm in a longer part and 16 mm in a shorter part in the drawing. An end part having a width of 10 mm of the adhesion preventing plate 101 is attached to the protection target member 102 so as to make contact therewith. Further, a gap between the adhesion preventing plate 101 and the protection target member 102 is set to 1.2 mm in a part other than the contact surface. That is, in the above form, vacuum insulation is used as the first insulation member. Because the film formation species is nickel, pure nickel is used as the material of the sputtering target 104. In consideration of reusing the adhesion preventing plate 101 by removing a nickel film adhered thereto by chemical cleaning, austenitic stainless (SUS304) is used as the material of the adhesion preventing plate 101.

Sputtering was performed using the sputtering electrode described above with the pressure inside the vacuum chamber adjusted to 0.5 Pa by introducing 500 sccm of argon gas, and the film formation experiment was performed with an output and for a time sufficient for forming a film having a total thickness of approximately 1 mm on a work piece (not illustrated). As a result, a sputtered film having a thickness slightly less than 1 mm in maximum was formed on the adhesion preventing plate 101, and the peel-off of the film did not occur at all. Further, the highest temperature of the adhesion preventing plate in this case was 300°C.

### [Example 2]

The same test as in Example 1 was performed using a structure that is substantially the same as the structure in Example 1 excepting that the cooling water path 103 is not provided in the protection target member 102. The structure of the adhesion preventing plate is completely the same as that in Example 1.

As a result, a sputtered film having a thickness slightly less than 1 mm in maximum was formed on the adhesion preventing plate 101, and the peel-off of the film did not occur at all.

### [Example 3]

A structure that is substantially the same as the structure in Example 1 excepting that the adhesion preventing plate 101 is placed so that an end part having a width of 20 mm thereof is fixed to the protection target member 102 was used. Sputtering was performed using this sputtering electrode, and the film formation experiment was performed for a time sufficient for forming a film having a total thickness of approximately 0.4 mm on a work (not illustrated).

As a result, a sputtered film having a thickness slightly less than 0.4 mm in maximum was formed on the adhesion preventing plate 101, and the peel-off of the film did not occur at all. Thereafter, when a film was formed up to a thickness of 1 mm, although peel-off was not observed during the film formation, slight peel-off of a film adhered to the adhesion preventing plate 101 was confirmed when the vacuum chamber is open to the atmosphere after the completion of the film formation.

### [Comparative Example 1]

The same test as in Example 1 was performed using a structure that is substantially the same as the structure in Example 1 excepting that the adhesion preventing plate 101 is not provided in an electrode.

As a result, a film adhered to the protection target member 102 came off into crumbled pieces during the film formation, and abnormal discharge occurred many times.

### [Comparative Example 2]

The same test as in Example 1 was performed using a structure that is substantially the same as the structure in Example 1 excepting that no gap is formed between the protection target member 102 and the adhesion preventing plate 101.

As a result, a film adhered to the adhesion preventing plate 101 came off into crumbled pieces during the film formation, and abnormal discharge occurred many times. Further, in this test, the highest temperature of the adhesion preventing plate 101 was 50°C.

### INDUSTRIAL APPLICABILITY

Although the present invention is applicable not only to an adhesion preventing plate for a sputtering electrode, but also to an adhesion preventing plate for a vacuum film formation apparatus such as a deposition apparatus and a CVD apparatus, the range of application is not limited thereto.

### DESCRIPTION OF REFERENCE SIGNS

- 101:: Adhesion preventing plate
- 102:: Protection target member
- 103:: Cooling water path
- 104:: Sputtering target
- 105:: Sputtering electrode
- 106:: Discharge space
- 201:: Vacuum chamber
- 202:: Partition wall
- 203:: Unwinder
- 204:: Main roller
- 205:: Winder
- 206:: Substrate
- 207:: Vacuum chamber wall surface
- 208:: Vacuum chamber bottom surface
- 209:: Vacuum chamber top surface

## Claims

1. A vacuum film formation apparatus forming a film of a film formation substance on a substrate, the vacuum film formation apparatus comprising:
an adhesion preventing plate arranged to cover at least a part of a protection target member cooled by cooling means, the adhesion preventing plate preventing adhesion of particles of the film formation substance to the protection target member, wherein
the adhesion preventing plate is arranged in such a manner that the area of a contact surface between other structure including the protection target member and the adhesion preventing plate is made smaller than the area of a film adhesion surface of the adhesion preventing plate to which particles of the film formation substance are adhered, and a first heat insulation member is provided between a surface other than the contact surface of the adhesion preventing plate, the surface facing the protection target member, and other structure including the protection target member.

2. The vacuum film formation apparatus according to claim 1, wherein the protection target member is adjacent to a film formation source.

3. The vacuum film formation apparatus according to claim 1 or 2, wherein the thickness of the first heat insulation member is in the range of 0.3 mm to 10 mm.

4. The vacuum film formation apparatus according to any of claims 1 to 3, wherein the contact surface between other structure including the protection target member and the adhesion preventing plate is provided only on the far side from the film formation source of the film formation substance.

5. The vacuum film formation apparatus according to any of claims 1 to 4, wherein the adhesion preventing plate is placed so as to make contact with other structure including the protection target member and the adhesion preventing plate at the end of the adhesion preventing plate.

6. The vacuum film formation apparatus according to any of claims 1 to 5, wherein a thermal spraying film is formed on the film adhesion surface of the adhesion preventing plate by a thermal spraying method.

7. The vacuum film formation apparatus according to any of claims 1 to 6, wherein a second heat insulation member is attached to a contact surface on which a member to which the adhesion preventing plate is attached and the adhesion preventing plate make contact with each other so as to be interposed between the member and the adhesion preventing plate.

8. A vacuum film formation method comprising: forming a film of a film formation substance on a substrate using the vacuum film formation apparatus according to any of claims 1 to 7.
